# DEMANDE DE BREVET EUROPEEN

(11) **EP 4 270 023 A1**
(43) Date de publication de la demande: **01.11.2023**
(21) Numéro de dépôt: 23164895.7
(22) Date de dépôt: 29.03.2023
(51) Int. Cl.: G01R 31/08, G01R 31/12

(54) **DISPOSITIF DE SURVEILLANCE DU FONCTIONNEMENT DE CÂBLES ÉLECTRIQUES DANS UN RÉSEAU MAILLÉ**

(30) Priorité: 26.04.2022 FR 2203851
(71) Demandeur: Nexans, 92400 Courbevoie (FR)
(72) Inventeur: GRIOT, Samuel, 69007 LYON (FR); CHARRIER, Dimitri, 69130 ECULLY (FR); KAFAL, Moussa, 91940 LES ULIS (FR)
(74) Mandataire: Ipsilon

(57) **Abrégé**

Ce dispositif (10) de surveillance du fonctionnement d'une pluralité de câbles électriques, accessoires de connexion ou de raccordement, appareillages et transformateurs compris dans un réseau électrique maillé comportant une pluralité de branches d'extrémité (16) et une pluralité de branches intermédiaires (14) comporte le réseau électrique maillé, au moins deux capteurs inductifs (12) adaptés à détecter une décharge partielle survenant dans le réseau électrique maillé et un moyen (18) de localisation de la source de la décharge partielle (PD).

## Description

La présente invention se rapporte à un dispositif de surveillance du fonctionnement de câbles électriques dans un réseau maillé. Plus particulièrement, la présente invention concerne la surveillance du fonctionnement de l'ensemble des câbles électriques, accessoires de connexion ou de raccordement, des appareillages et des transformateurs dans un réseau électrique maillé, par exemple à moyenne tension ou HTA (Haute Tension A). Cet ensemble est dénommé ci-après réseau électrique.

L'invention appartient au domaine des réseaux électriques de puissance destinés au transport d'énergie. Elle trouve à s'appliquer en particulier, mais pas uniquement, dans le domaine de la distribution d'énergie au travers des réseaux électriques à moyenne tension HTA ainsi que des réseaux électriques industriels à moyenne tension.

L'évaluation de la santé d'un réseau électrique et d'une installation comportant des câbles, des accessoires de connexion, des appareillages et des transformateurs est une tâche ardue, en particulier pour une quantité importante d'installations vieillissantes. Les clients souhaitent obtenir des informations fiables et précises concernant le réseau électrique.

Il existe des services hors connexion et sur site qui permettent d'évaluer la santé d'un câble à un emplacement donné d'un câble donné. Néanmoins, il s'agit d'évaluations ponctuelles, qui ne sont valables que pendant une durée limitée. En outre, de telles techniques ne peuvent être appliquées que sur des câbles hors tension et ne peuvent donc pas indiquer la dégradation du réseau électrique en temps réel.

Par ailleurs, il existe actuellement sur le marché quelques systèmes de mesure en ligne de paramètres relatifs au bon état d'un câble. Cependant, ces systèmes se limitent au diagnostic d'un seul câble et nécessitent de prévoir deux capteurs par câble. La surveillance d'un grand nombre de câbles implique donc l'utilisation d'un grand nombre de capteurs, ce qui augmente le coût et la complexité du système de surveillance.

Lorsqu'on souhaite surveiller plus d'un câble au sein d'un réseau électrique maillé, on peut utiliser une technique de réflectométrie. Toutefois, la réflectométrie utilisée comme technique de test active basée sur l'injection de signaux de test est capable de localiser des défauts dans les câbles, sous forme d'effilochages, de dommages à l'isolation, de fissures, etc. Cette technique est généralement moins sensible aux points faibles que celles générant des décharges partielles. Cette technique est donc moins appropriée et nettement moins sensible à la mesure des signaux précurseurs du vieillissement des réseaux électriques.

La présente invention a pour but de remédier aux inconvénients précités de l'art antérieur.

Dans ce but, la présente invention propose un dispositif de surveillance du fonctionnement d'une pluralité de câbles électriques, accessoires de connexion ou de raccordement, appareillages et transformateurs compris dans un réseau électrique maillé comportant une pluralité de branches d'extrémité et une pluralité de branches intermédiaires, le dispositif comportant le réseau électrique maillé et étant remarquable en ce qu'il comporte en outre :
au moins deux capteurs inductifs adaptés à détecter une décharge partielle survenant dans le réseau électrique maillé ;
un moyen de localisation de la source de la décharge partielle.

Ce dispositif n'implique aucune condition quant à l'alimentation des câbles, ne se restreint pas à une topologie de câble unique et linéaire et permet d'optimiser la quantité de capteurs. L'analyse des signaux de décharge partielle permet d'identifier de façon simple la présence d'anomalies ou de points faibles dans le réseau électrique maillé.

En outre, ce dispositif supprime la nécessité de prévoir deux capteurs par câble et permet ainsi de réduire la complexité de l'installation et les opérations humaines requises pour la surveillance du réseau électrique maillé considéré.

Dans un mode particulier de réalisation, les au moins deux capteurs inductifs sont des transformateurs de courant à haute fréquence.

La largeur de bande de tels capteurs s'étend de quelques centaines de kHz jusqu'à environ 100 MHz, ce qui est particulièrement bien adapté aux fréquences d'impulsions des décharges partielles dues aux anomalies susceptibles de survenir dans les réseaux électriques.

Dans un mode particulier de réalisation, les au moins deux capteurs inductifs sont placés uniquement sur des branches intermédiaires du réseau électrique maillé.

Cela permet de réduire le nombre de capteurs inductifs tout en évitant de rencontrer une difficulté d'accessibilité à certaines branches d'extrémité du réseau électrique maillé pour y brancher un capteur, sachant que de toute façon, la probabilité de détecter une anomalie ne dépend pas de la distance entre l'emplacement de cette anomalie et les capteurs et qu'une anomalie située sur le trajet direct entre deux capteurs sera systématiquement localisée.

Dans un mode particulier de réalisation, la pluralité de branches d'extrémité et la pluralité de branches intermédiaires comportent un sous-ensemble de branches à surveiller en priorité et les au moins deux capteurs inductifs sont placés dans le réseau électrique maillé de façon que chaque branche du sous-ensemble de branches à surveiller en priorité soit contenue entre deux capteurs des au moins deux capteurs inductifs.

Cette caractéristique relative au positionnement des capteurs inductifs dans le réseau électrique maillé est avantageuse car elle permet la détection systématique de toute anomalie dans toute branche à surveiller en priorité. Les branches à surveiller en priorité sont celles qui comportent des câbles, des accessoires de connexion ou de raccordement, des appareillages ou des transformateurs correspondant à des fonctions cruciales, c'est-à-dire où un dysfonctionnement aurait un impact significatif pour le client, voire présenterait un risque sérieux en matière de continuité de service.

Dans un mode particulier de réalisation, les au moins deux capteurs inductifs sont placés dans le réseau électrique maillé de façon à maximiser le nombre de branches intermédiaires contenues entre deux capteurs des au moins deux capteurs inductifs.

Cette autre caractéristique relative au positionnement des capteurs inductifs dans le réseau électrique maillé est avantageuse car elle permet de maximiser la détection d'anomalies dans les branches intermédiaires ou dérivées du réseau électrique maillé, sachant qu'une anomalie située entre deux capteurs sera systématiquement localisée.

Dans un mode particulier de réalisation, les au moins deux capteurs inductifs sont placés en priorité sur les branches du réseau électrique maillé qui présentent les longueurs les plus importantes.

Cela permet de maximiser la longueur de liaison couverte par le dispositif de surveillance.

Dans un mode particulier de réalisation, le réseau électrique maillé comporte un nombre de capteurs inductifs inférieur au nombre de branches d'extrémité et un nombre de branches d'extrémité inférieur au nombre de branches intermédiaires.

Cela permet de minimiser le nombre de capteurs inductifs tout en surveillant une couverture suffisante du réseau électrique maillé.

Dans un mode particulier de réalisation, le moyen de localisation de la source de la décharge partielle est adapté à appliquer un algorithme de temps de vol.

Cet algorithme, qui permet de connaître le temps écoulé entre l'émission et la réception d'un signal, fournit ainsi une indication précise de l'emplacement du réseau électrique maillé où l'anomalie ayant provoqué la décharge partielle s'est produite.

### Brève description des dessins

D'autres aspects et avantages de l'invention apparaîtront à la lecture de la description détaillée ci-après de modes particuliers de réalisation, donnés à titre d'exemples nullement limitatifs, en référence aux dessins annexés, dans lesquels :

[Fig. 1] est une représentation schématique partielle d'un réseau électrique maillé compris dans un dispositif conforme à la présente invention montrant les caractéristiques d'un tel dispositif, dans un mode particulier de réalisation ;

[Fig. 2] est une représentation schématique partielle d'un réseau électrique maillé compris dans un dispositif conforme à la présente invention montrant des emplacements possibles pour des capteurs, dans un autre mode particulier de réalisation.

### Description de mode(s) de réalisation

Le dispositif conforme à la présente invention est un dispositif de surveillance du fonctionnement d'une pluralité de câbles électriques, accessoires de connexion ou de raccordement, appareillages et transformateurs compris dans un réseau électrique maillé.

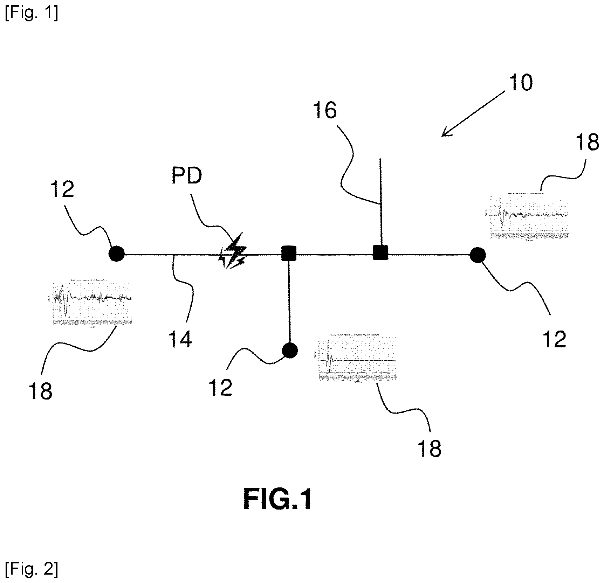

Comme le montre la figure 1, le réseau électrique maillé comporte une pluralité de branches d'extrémité 16 et une pluralité de branches intermédiaires 14. Une branche intermédiaire 14 est définie comme n'étant pas une branche d'extrémité.

Le dispositif 10 de surveillance comporte le réseau électrique maillé.

Conformément à la présente invention, le dispositif 10 comporte en outre au moins deux capteurs inductifs 12 adaptés à détecter une décharge partielle PD survenant dans le réseau électrique maillé.

L'analyse du graphe représentant le signal de décharge partielle permet d'identifier la présence d'une anomalie ou d'un point faible dans un câble ou autre équipement électrique du réseau électrique maillé. Ce graphe peut par exemple représenter l'amplitude en fonction du temps de l'impulsion électromagnétique de la décharge partielle PD transformée en un signal de courant.

A titre d'exemple nullement limitatif, les capteurs inductifs 12 peuvent être des transformateurs de courant à haute fréquence ou HFCT (en anglais « High Frequency Current Transformers »), utilisés ici comme capteurs à couplage inductif et fixés à des emplacements prédéfinis du réseau électrique maillé.

Conformément à la présente invention, le dispositif 10 comporte également un moyen 18 de localisation de la source de la décharge partielle PD.

A titre d'exemple nullement limitatif, le moyen 18 de localisation de la source de la décharge partielle PD peut être adapté à appliquer un algorithme de temps de vol. Il consiste de façon connue en soi à émettre un signal, obtenir le temps de trajet de ce signal entre son émission et sa réception et en déduire la localisation de la décharge partielle PD dans le réseau électrique maillé, ce qui permet d'identifier le câble ou autre équipement électrique qui a subi l'anomalie ayant provoqué cette décharge partielle PD.

Dans un mode particulier de réalisation, les capteurs inductifs 12 peuvent être placés uniquement sur des branches intermédiaires 14 du réseau électrique maillé. En effet, le branchement de capteurs à toutes les extrémités d'un réseau électrique maillé est coûteux et n'est du reste pas toujours possible en fonction de l'accessibilité de ces branches.

Dans un mode particulier de réalisation, afin de maximiser la probabilité de détecter une anomalie sur une branche intermédiaire 14 du réseau électrique maillé, les capteurs inductifs 12 peuvent être placés dans le réseau électrique maillé de façon à maximiser le nombre de branches intermédiaires 14 ou dérivées contenues entre deux capteurs inductifs 12.

Dans un mode particulier de réalisation, l'ensemble de branches constitué de la pluralité de branches d'extrémité 16 et de la pluralité de branches intermédiaires 14 comporte un sous-ensemble de branches à surveiller en priorité. Ce sous-ensemble est défini en fonction de l'importance, pour le bon fonctionnement du réseau électrique maillé, des équipements électriques et des câbles présents sur ces branches et de l'importance de l'impact d'un dysfonctionnement sur le réseau électrique maillé. A contrario, on décidera qu'une branche n'est pas à surveiller en priorité si en cas de défaillance sur cette branche, le réseau peut continuer à fonctionner, même en mode dégradé.

Dans ce mode de réalisation, les capteurs inductifs 12 sont alors placés dans le réseau électrique maillé de façon que chaque branche du sous-ensemble de branches à surveiller en priorité soit contenue entre deux capteurs inductifs 12. Ainsi, ces capteurs inductifs 12 détecteront systématiquement toute décharge partielle PD sur toutes les branches à surveiller en priorité.

Dans un mode particulier de réalisation, afin d'optimiser la couverture de la surveillance du réseau électrique maillé par le dispositif 10 conforme à la présente invention, les capteurs inductifs 12 peuvent être placés en priorité sur les branches du réseau électrique maillé qui présentent les longueurs les plus importantes.

A titre d'exemple nullement limitatif, le réseau électrique maillé peut comporter un nombre K de capteurs inductifs 12 inférieur au nombre M de branches d'extrémité 14 et un nombre M de branches d'extrémité 16 inférieur au nombre N de branches intermédiaires 14.

On peut distinguer deux facteurs principaux pour décider du positionnement et du nombre de capteurs inductifs 12.

Le premier facteur réside dans la nature des équipements électriques connectés au réseau électrique maillé (transformateur, dispositif de commutation, etc.) et la situation du câble proprement dit (phases séparées, faisceau unique, etc.). Ce premier facteur permet de spécifier le meilleur emplacement pour fixer le capteur et également les conducteurs les plus appropriés à surveiller (phase à phase, phase à blindage, etc.).

Le second facteur est déterminé par les caractéristiques de propagation des impulsions de décharge partielle PD dans le câble surveillé. Plus précisément, les hypothèses de plus forte atténuation et de plus forte dispersion sont prises en compte et, par projection de ces hypothèses sur l'événement à l'origine de la décharge partielle PD, le nombre optimal de capteurs inductifs 12 pour un réseau donné peut être défini.

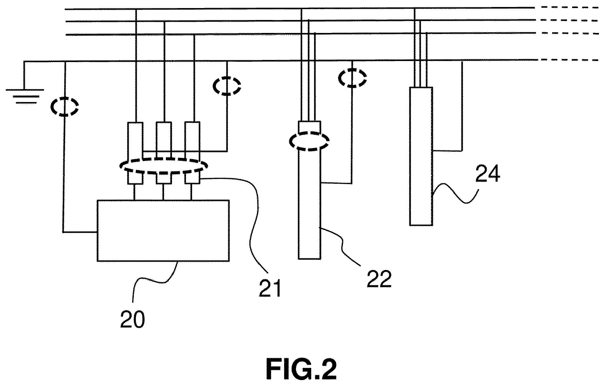

Sur la figure 2, les ellipses en pointillés illustrent des emplacements possibles pour les capteurs inductifs 12. L'élément 20 est un équipement électrique, l'élément 21 désigne des câbles de sortie de l'élément électrique 20, l'élément 22 est un câble à surveiller et l'élément 24 est un autre câble, par exemple un câble à moyenne tension.

A titre d'exemple nullement limitatif, le processus de détermination de l'emplacement des capteurs inductifs 12 peut être le suivant :
identifier les branches du réseau électrique maillé présentant un niveau de priorité élevé,
identifier les branches intermédiaires 14 du réseau électrique maillé,
trier les branches suivant leur longueur,
dans la mesure du possible, placer les capteurs inductifs 12 de façon que les
branches à priorité élevée soient contenues entre au moins deux capteurs inductifs 12,
placer les capteurs inductifs 12 de façon à maximiser le nombre de branches intermédiaires 14 contenues entre au moins deux capteurs inductifs 12,
placer les capteurs inductifs 12 restants sur les autres branches du réseau électrique maillé, en commençant par les branches de plus grande longueur.

En suivant un tel processus, on maximise le nombre de branches surveillées ainsi que la longueur surveillée. Les branches non surveillées seront majoritairement des branches d'extrémité 16, considérées comme présentant un moindre risque et plus courtes que les branches surveillées.

## Revendications

1. Dispositif (10) de surveillance du fonctionnement d'une pluralité de câbles électriques, accessoires de connexion ou de raccordement, appareillages et transformateurs compris dans un réseau électrique maillé comportant une pluralité de branches d'extrémité (16) et une pluralité de branches intermédiaires (14), ledit dispositif (10) comportant ledit réseau électrique maillé et étant **caractérisé en ce qu'**il comporte en outre : au moins deux capteurs inductifs (12) adaptés à détecter une décharge partielle (PD) survenant dans ledit réseau électrique maillé ; un moyen (18) de localisation de la source de ladite décharge partielle (PD).

2. Dispositif (10) selon la revendication 1, **caractérisé en ce que** lesdits au moins deux capteurs inductifs (12) sont des transformateurs de courant à haute fréquence.

3. Dispositif (10) selon la revendication 1 ou 2, **caractérisé en ce que** lesdits au moins deux capteurs inductifs (12) sont placés uniquement sur des branches intermédiaires (14) dudit réseau électrique maillé.

4. Dispositif (10) selon la revendication 1, 2 ou 3,
**caractérisé en ce que** ladite pluralité de branches d'extrémité (16) et ladite pluralité de branches intermédiaires (14) comportent un sous-ensemble de branches à surveiller en priorité et **en ce que** lesdits au moins deux capteurs inductifs (12) sont placés dans ledit réseau électrique maillé de façon que chaque branche dudit sous-ensemble de branches à surveiller en priorité soit contenue entre deux capteurs desdits au moins deux capteurs inductifs (12).

5. Dispositif (10) selon l'une quelconque des revendications précédentes, **caractérisé en ce que** lesdits au moins deux capteurs inductifs (12) sont placés dans ledit réseau électrique maillé de façon à maximiser le nombre de branches intermédiaires (14) contenues entre deux capteurs desdits au moins deux capteurs inductifs (12).

6. Dispositif (10) selon l'une quelconque des revendications précédentes, **caractérisé en ce que** lesdits au moins deux capteurs inductifs (12) sont placés en priorité sur les branches dudit réseau électrique maillé qui présentent les longueurs les plus importantes.

7. Dispositif (10) selon l'une quelconque des revendications précédentes, **caractérisé en ce que** ledit réseau électrique maillé comporte un nombre de capteurs inductifs (12) inférieur au nombre de branches d'extrémité (16) et un nombre de branches d'extrémité (16) inférieur au nombre de branches intermédiaires (14).

8. Dispositif (10) selon l'une quelconque des revendications précédentes, **caractérisé en ce que** ledit moyen (18) de localisation de la source de ladite décharge partielle (PD) est adapté à appliquer un algorithme de temps de vol.
